# DEMANDE DE BREVET EUROPEEN

(11) **EP 3 671 843 A1**
(43) Date de publication de la demande: **24.06.2020**
(21) Numéro de dépôt: 19217669.1
(22) Date de dépôt: 18.12.2019
(51) Int. Cl.: H01L 27/15, H01L 33/38

(54) **PROCEDE DE FABRICATION D'UNE PLURALITE DE DIODES A PARTIR D'UN SUBSTRAT DE LECTURE**

(30) Priorité: 21.12.2018 FR 1873790
(71) Demandeur: COMMISSARIAT À L'ÉNERGIE ATOMIQUE ET AUX ÉNERGIES ALTERNATIVES, 75015 Paris (FR)
(72) Inventeur: LE PERCHEC, Jérôme, 38054 GRENOBLE CEDEX 09 (FR); CERVERA, Cyril, 38054 GRENOBLE CEDEX 09 (FR); PERNEL, Carole, 38054 GRENOBLE CEDEX 09 (FR)
(74) Mandataire: Dupont, Jean-Baptiste

(57) **Abrégé**

L'invention porte sur un procédé de fabrication d'un dispositif optoélectronique (1) comportant une pluralité de diodes (40), comportant les étapes suivantes :
∘ fourniture d'un substrat de lecture (10) contenant un circuit de lecture (12), et présentant une face de croissance définie par une pluralité de portions conductrices (20), distinctes les uns des autres, et connectées au circuit de lecture (12) ;
∘ réalisation, sur la face de croissance, d'une pluralité de portions de nucléation (30) en un matériau cristallin bidimensionnel, distinctes les unes des autres, et reposant au contact des portions conductrices (20) ;
∘ réalisation, par épitaxie à partir des portions de nucléation (30), de la pluralité de diodes.

## Description

### DOMAINE TECHNIQUE

Le domaine de l'invention est celui des dispositifs optoélectroniques à matrice de photodiodes ou de diodes électroluminescentes, et porte notamment sur un procédé de fabrication d'un tel dispositif optoélectronique à partir d'un substrat de lecture. L'invention s'applique notamment au domaine de la photodétection d'un rayonnement infrarouge.

### ÉTAT DE LA TECHNIQUE ANTÉRIEURE

Les procédés de fabrication des dispositifs optoélectroniques à matrice de diodes comportent généralement une étape d'hybridation, au cours de laquelle deux puces microélectroniques sont assemblées mécaniquement et connectées électriquement l'une à l'autre. Les puces microélectroniques peuvent alors être une puce optoélectronique comportant la matrice de diodes, et une puce de commande comportant un circuit de lecture assurant la lecture et/ou la commande des diodes. Les diodes peuvent être des photodiodes ou des diodes électroluminescentes. Différentes approches d'hybridation existent, décrites notamment dans l'article de A. Rogalski intitulé Progress in focal plane array technologies, Progress in Quantum Electronics 36 (2012) 342-473.

Une première approche consiste ainsi à hybrider les puces microélectroniques par des plots d'interconnexion, par exemple des billes d'indium. Les puces microélectroniques sont alors assemblées au niveau de leur face de connexion respective, où chaque puce comporte une matrice de plots d'interconnexion électrique. Le procédé d'hybridation comporte alors une étape d'alignement et de mise en contact des plots d'interconnexion, deux à deux, suivie d'une étape d'application d'une température dite d'hybridation, réalisant ainsi un lien mécanique entre les deux puces par fusion ou inter-diffusion des plots d'interconnexion de l'une et/ou de l'autre puce microélectronique. Cependant, un tel procédé de fabrication comporte un risque de désalignement entre les plots d'interconnexion, pouvant alors entraîner une perte de contact mécanique et donc un défaut de connexion électrique entre les plots d'interconnexion respectifs. Ce risque est d'autant plus élevé que la matrice de diodes comporte un grand nombre de diodes à faible pas.

Une autre approche d'hybridation, dite *loophole,* consiste à assembler une puce optoélectronique comportant un empilement de couches semiconductrices destinées à former les diodes à une puce de commande au moyen d'une couche intermédiaire de collage. Des diodes traversantes sont ensuite réalisées par gravure localisée de l'empilement semiconducteur et dopage des flancs des tranchées. Les tranchées débouchent sur des plots de connexion de la puce de commande et sont métallisées pour assurer la connexion électrique entre les diodes et le circuit de lecture. Cependant, l'efficacité de collage doit être optimale sur toute la surface de collage entre les puces microélectroniques, ce qui est d'autant plus difficile à obtenir lorsque la matrice de diodes est importante. Il y a en effet un risque de décollement localisé entre les puces microélectroniques, pouvant alors conduire à un défaut de connexion électrique des diodes au circuit de lecture.

Il existe donc un besoin de disposer d'un procédé de fabrication qui permette de réduire les risques de perte de contact mécanique et donc de défaut de connexion électrique entre les diodes et le circuit de lecture, notamment lorsque la matrice de diodes comporte un grand nombre de diodes à faible pas. Il existe également un besoin de disposer de diodes réalisées en un matériau semiconducteur présentant une qualité cristalline élevée, et donc une efficacité quantique importante.

On connaît également le document WO2015/044619A1 qui décrit une pluralité de diodes électroluminescentes sous forme de nanofils épitaxiés à partir d'un substrat de croissance. Ce substrat de croissance est réalisé à base d'un matériau semiconducteur cristallin. Le circuit de lecture, qui comporte des lignes métalliques, est situé à l'extérieur et non pas à l'intérieur de ce substrat de croissance.

### EXPOSÉ DE L'INVENTION

L'invention a pour objectif de remédier au moins en partie aux inconvénients de l'art antérieur, et plus particulièrement de proposer un procédé permettant de fabriquer un dispositif optoélectronique comportant une pluralité de diodes, permettant d'écarter les risques de perte de contact mécanique et donc de défaut de connexion électrique entre les diodes et le circuit de lecture.

Le procédé de fabrication selon l'invention permet également d'obtenir des diodes dont la qualité cristalline du matériau semiconducteur qui les compose est élevée, permettant ainsi d'améliorer les performances optiques et/ou électroniques du dispositif optoélectronique.

Pour cela, l'objet de l'invention est un procédé de fabrication d'un dispositif optoélectronique comportant une pluralité de diodes, comportant les étapes suivantes :
∘ fourniture d'un substrat de lecture contenant un circuit de lecture comportant des lignes métalliques séparées les unes des autres par des couches diélectriques dites inter-métal, et présentant une face de croissance définie par une pluralité de portions conductrices en au moins un matériau métallique, distinctes les unes des autres, et connectées au circuit de lecture ;
∘ réalisation, sur la face de croissance, d'une pluralité de portions de nucléation en un matériau cristallin bidimensionnel, distinctes les unes des autres, et reposant au contact des portions conductrices ;
∘ réalisation, par épitaxie à partir des portions de nucléation, de la pluralité de diodes.

Autrement dit, le substrat de croissance est un substrat fonctionnalisé par la présence du circuit de lecture, et donc appelé substrat de lecture. Celui-ci comporte donc plusieurs lignes métalliques s'étendant sur plusieurs niveaux d'interconnexion, lesquelles sont séparées entre elles par des couches diélectriques inter-métal et sont reliées entre elles par des vias métalliques. Le substrat de croissance se distingue ainsi du substrat du document WO2015/044619A1 en ce qu'il comporte un tel circuit de lecture. Pour assurer la nucléation et l'épitaxie du matériau cristallin des diodes, les portions de nucléations sont réalisées en un matériau cristallin bidimensionnel, c'est-à-dire qu'il est formé d'une ou plusieurs monocouches, chaque monocouche ayant un réseau cristallin bidimensionnel et non pas tridimensionnel.

Certains aspects préférés mais non limitatifs de ce procédé de fabrication sont les suivants.

Le substrat de lecture peut présenter une face supérieure plane, les portions conductrices étant en saillie vis-à-vis de la face supérieure plane.

Le substrat de lecture peut présenter une face supérieure plane, les portions conductrices affleurant la face supérieure plane.

Les portions conductrices peuvent reposer au contact de portions des lignes métalliques du circuit de lecture ou former des portions de lignes métalliques de ce circuit de lecture.

Chaque portion conductrice peut comporter :
▪ une zone dite principale revêtue par la portion de nucléation et destinée à être revêtue par la diode, et
▪ une zone dite latérale revêtue partiellement par la portion de nucléation de sorte que celle-ci présente une face latérale reliant des faces inférieure et supérieure de la portion de nucléation, et destinée à ne pas être revêtue par la diode, et s'étendant dans un plan parallèle au substrat de lecture à partir de la zone principale,
∘ le procédé comportant une étape de réalisation d'une partie dite latérale supérieure de la portion conductrice s'étendant continûment au contact de la zone latérale et au contact de la face latérale de la portion de nucléation. La partie latérale supérieure peut également être au contact d'une surface inférieure d'une face latérale de la diode.

Le procédé de fabrication peut comporter les étapes suivantes :
- la fourniture du substrat de lecture, de sorte que chaque portion conductrice comporte une zone principale et une zone latérale s'étendant dans un plan parallèle au substrat de lecture à partir de la zone principale ;
- la réalisation de la pluralité de portions de nucléation, de sorte que chaque zone principale est revêtue par la portion de nucléation, et que chaque zone latérale n'est revêtue que partiellement par la portion de nucléation, chaque portion de nucléation présente ainsi une face latérale située au-dessus de la zone latérale de la portion conductrice, reliant une face inférieure de la portion de nucléation au contact de la portion conductrice à une face supérieure opposée ;
- une réalisation d'une partie latérale supérieure de la portion conductrice, s'étendant au contact de la zone de celle-ci non revêtue par la portion de nucléation, et au contact de la face latérale de la portion de nucléation ;
- la réalisation de la pluralité de diodes, de sorte que chaque diode ne revêt que la zone principale et non pas la zone latérale de la portion conductrice.

Chaque portion conductrice peut comporter :
▪ une zone dite principale revêtue par la portion de nucléation et par la diode, et
▪ une zone dite latérale non revêtue par la diode, et s'étendant dans un plan parallèle au substrat de lecture à partir de la zone principale,
∘ le procédé comportant une étape de réalisation d'une partie dite latérale supérieure de la portion conductrice s'étendant continûment au contact de la zone latérale et au contact d'une surface inférieure d'une face latérale de la diode. La partie latérale supérieure peut également être au contact de la face latérale de la portion de nucléation.

Le procédé de fabrication peut comporter les étapes suivantes :
- la fourniture du substrat de lecture, de sorte que chaque portion conductrice comporte une zone principale et une zone latérale s'étendant dans un plan parallèle au substrat de lecture à partir de la zone principale ;
- la réalisation de la pluralité de portions de nucléation, de sorte que chaque zone principale est revêtue par la portion de nucléation, et que chaque zone latérale n'est revêtue que partiellement par la portion de nucléation, chaque portion de nucléation présente ainsi une face latérale située au-dessus de la zone latérale de la portion conductrice, reliant une face inférieure de la portion de nucléation au contact de la portion conductrice à une face supérieure opposée ;
- la réalisation de la pluralité de diodes, de sorte que chaque diode ne revêt que la zone principale et non pas la zone latérale de la portion conductrice ;
- une réalisation d'une partie latérale supérieure de la portion conductrice, s'étendant au contact de la zone de celle-ci non revêtue par la portion de nucléation, et au contact d'une surface inférieure d'une face latérale de la diode.

Le procédé peut comporter, au préalable de l'étape de réalisation de la partie latérale supérieure, une étape de gravure partielle isotrope sélective des diodes à partir d'une face latérale des diodes, la face latérale des diodes reliant une face inférieure au contact des portions de nucléation et une face supérieure opposée, de sorte que la surface inférieure est inclinée suivant un axe orthogonal au plan du substrat de lecture.

Le procédé peut comporter une étape de réalisation d'une couche isolante intercalaire, s'étendant au contact des diodes dans un plan parallèle au substrat de lecture, et remplissant l'espacement entre les diodes.

La couche isolante intercalaire peut comporter une sous-couche de passivation s'étendant au contact d'une face latérale des diodes, et une couche de remplissage recouvrant la sous-couche de passivation et remplissant l'espacement inter-diode.

L'invention porte également sur un dispositif optoélectronique, comportant :
∘ un substrat de lecture, contenant un circuit de lecture, et comportant une pluralité de portions conductrices en au moins un matériau métallique, distinctes les unes des autres, définissant une face de croissance du substrat de lecture et connectées au circuit de lecture celui-ci comportant des lignes métalliques séparées les unes des autres par des couches diélectriques dites inter-métal ;
∘ une pluralité de portions de nucléation, distinctes les unes des autres, disposées au contact des portions conductrices, et réalisées en un matériau cristallin bidimensionnel ;
∘ une pluralité de diodes, situées au contact des portions de nucléation.

Les diodes peuvent être réalisées à base d'un matériau semiconducteur d'intérêt, lequel est un élément ou un composé de type II-VI, III-V, ou IV.

Chaque portion conductrice peut comporter une zone latérale revêtue partiellement par la portion de nucléation, et une partie dite latérale supérieure qui s'étend continûment au contact de la zone latérale et au contact d'une face latérale de la portion de nucléation.

Chaque portion conductrice peut comporter une zone latérale non revêtue par une diode, et une partie dite latérale supérieure qui s'étend continûment au contact de la zone latérale et au contact d'une surface inférieure d'une face latérale de la diode.

Au moins deux diodes peuvent être réalisées en un matériau semiconducteur présentant des compositions différentes.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

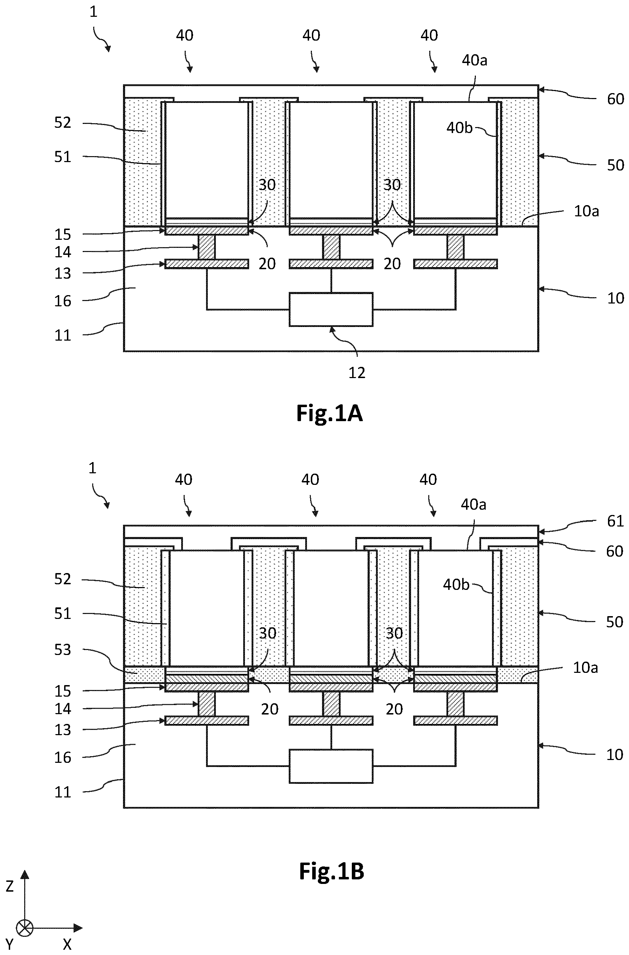

les figures 1A et 1B sont des vues schématiques et partielles, en coupe, de deux dispositifs optoélectroniques selon deux variantes de réalisation, dans lesquelles les portions conductrices affleurent la face supérieure plane du substrat de lecture (fig. 1A), ou sont en saillie vis-à-vis de la face supérieure plane (fig. 1B) ;

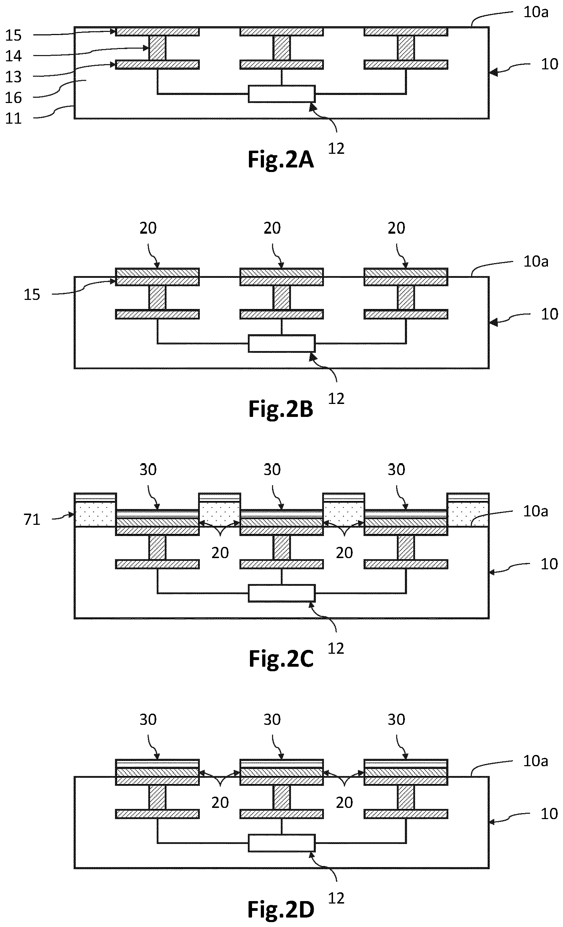

les figures 2A à 2G illustrent, de manière schématique et partielle, différentes étapes d'un procédé de fabrication d'un dispositif optoélectronique selon une variante du mode de réalisation illustré sur la fig. 1A, dans laquelle les portions conductrices sont en saillie vis-à-vis de la face supérieure plane du substrat de lecture ;

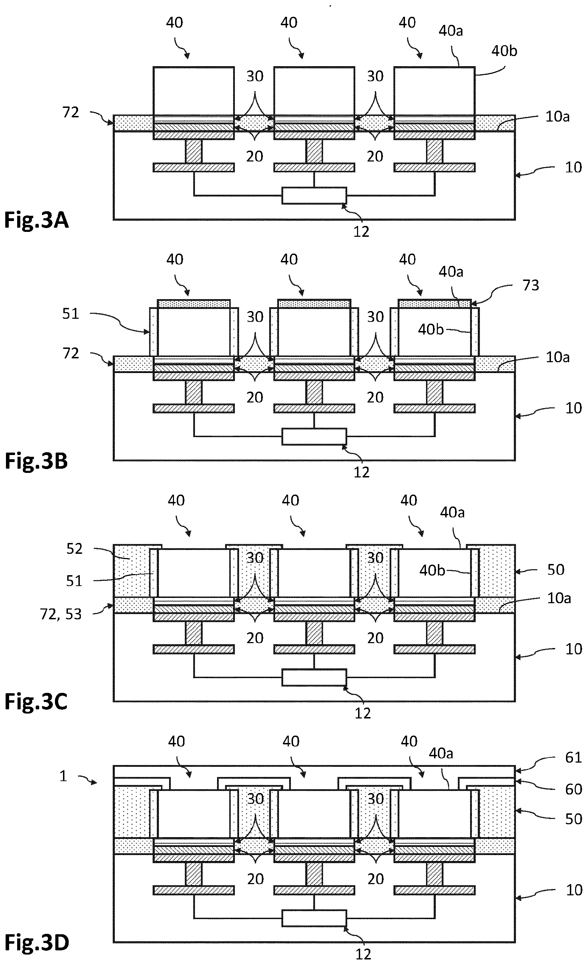

les figures 3A à 3D illustrent, de manière schématique et partielle, différentes étapes d'un procédé de fabrication du dispositif optoélectronique selon le mode de réalisation illustré sur la fig. 1B, dans lequel la couche isolante intercalaire comporte une partie inférieure située entre les portions conductrices et les portions de nucléation ;

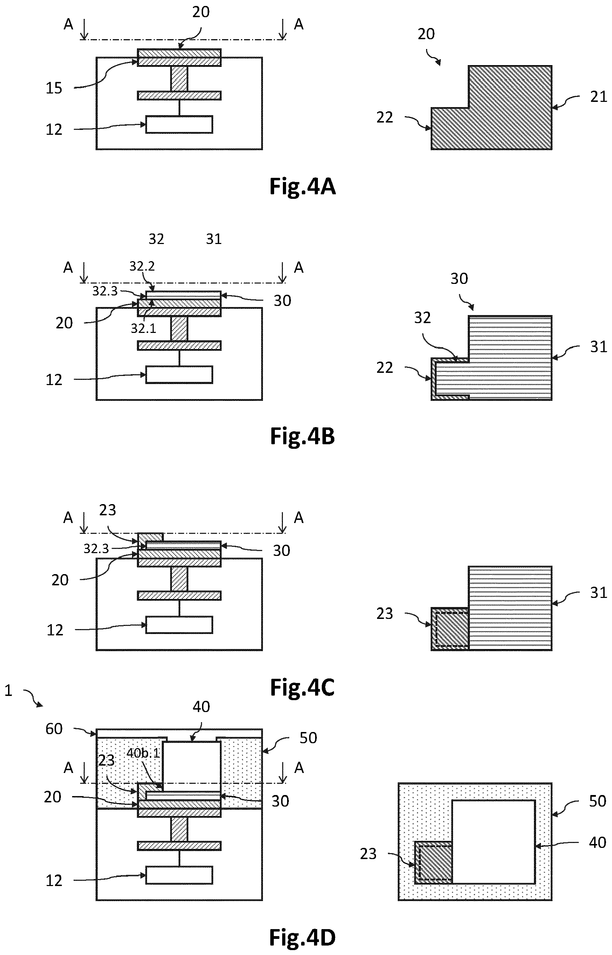

les figures 4A à 4D illustrent, de manière schématique et partielle, en vue en coupe et de dessus, différentes étapes d'un procédé de fabrication d'un dispositif optoélectronique selon un mode de réalisation, dans lequel chaque portion conductrice est formée de deux parties latérales encapsulant une partie latérale de la portion de nucléation correspondante ;

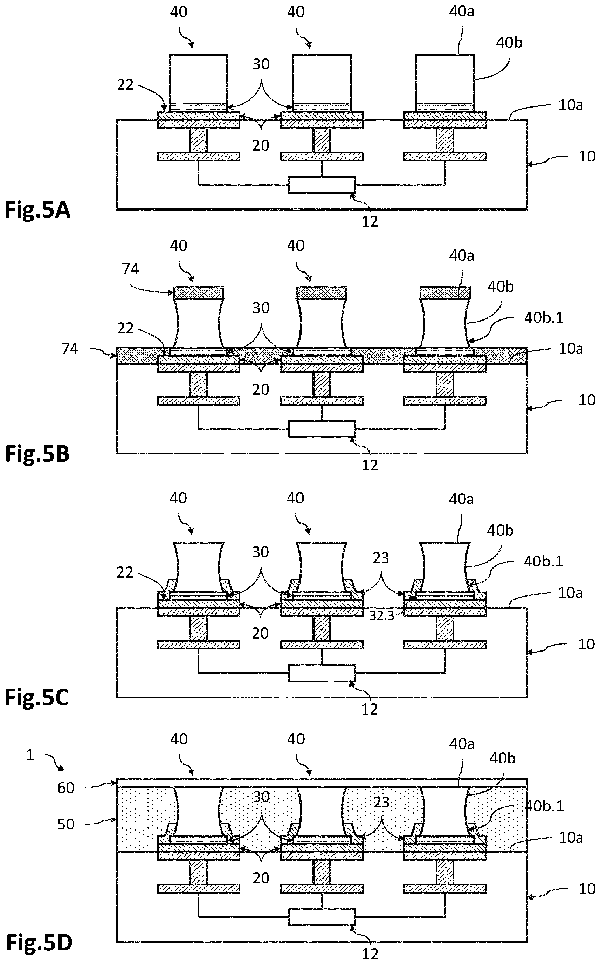

les figures 5A à 5D illustrent, de manière schématique et partielle, différentes étapes d'un procédé de fabrication d'un dispositif optoélectronique selon un mode de réalisation, dans lequel chaque portion conductrice comporte une partie latérale supérieure venant au contact d'une surface inférieure inclinée de la face latérale de la diode correspondante.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près.

L'invention porte sur un procédé de fabrication d'un dispositif optoélectronique comportant une pluralité de diodes à partir d'un substrat de lecture. Les diodes sont formées par épitaxie de type van der Waals à partir de portions de nucléation réalisées en un matériau cristallin bidimensionnel.

D'une manière générale, l'épitaxie de type van der Waals est une technique d'hétéroépitaxie par laquelle une couche semiconductrice cristalline est réalisée et liée à une couche de nucléation formée d'une ou plusieurs monocouches d'un matériau cristallin bidimensionnel par des liaisons de type van der Waals et non par des liaisons covalentes ou ioniques. L'épitaxie van der Waals permet notamment de s'affranchir du désaccord de maille pouvant exister entre le matériau cristallin bidimensionnel et la couche cristalline épitaxiée, ce désaccord de maille étant issu de la différence entre les paramètres de maille des deux matériaux, ce qui permet ainsi d'obtenir une couche cristalline épitaxiée relaxée ou quasi-relaxée. Une telle couche cristalline obtenue par épitaxie van der Waals présente alors une densité réduite de défauts structuraux tels que des dislocations de désaccord de maille, optimisant ainsi les propriétés optiques et/ou électroniques de la couche cristalline épitaxiée.

Le matériau de la couche de nucléation est un matériau cristallin dit bidimensionnel dans la mesure où il est formé d'une ou plusieurs monocouches ou de plusieurs monocouches empilées les unes sur les autres et liées entre elles par des interactions faibles, chaque monocouche étant formée d'atomes ou de molécules agencés de manière à former un réseau cristallin bidimensionnel. Une monocouche est une structure cristalline bidimensionnelle d'épaisseur monoatomique. Le matériau bidimensionnel peut être choisi parmi les chalcogénures de métaux de transition, tels que le sulfure ou séléniure de molybdène (MoS2, MoSe2) ou de tungstène (WS2), le graphène, le nitrure de bore dans sa structure bidimensionnelle (nitrure de bore hexagonal), entre autres. Les éventuelles monocouches de la couche de nucléation sont liées entre elles par des liaisons faibles de type van der Waals. De plus, la couche de nucléation est liée au matériau de la couche conductrice sous-jacente par des liaisons faibles de type van der Waals, non pas par des liaisons covalentes ou ioniques. Elle est liée au matériau semiconducteur des diodes par également des liaisons faibles de type van der Waals.

D'une manière générale, les diodes du dispositif optoélectronique peuvent être des photodiodes ou des diodes électroluminescentes, par exemple réalisées majoritairement à base d'un matériau semiconducteur d'intérêt, lequel peut être un élément semiconducteur ou un composé semiconducteur de type III-V, IV ou II-VI. Ainsi, à titre d'exemple, dans le cas de photodiodes, le matériau semiconducteur d'intérêt peut être choisi notamment parmi des éléments des colonnes II et VI du tableau de classification périodique, par exemple le CdHgTe, le CdTe ou le HgTe ; parmi des éléments des colonnes III et V, par exemple l'InGaAs et les alliages à base d'antimoine Sb ; voire parmi les éléments de la colonne IV, tels que le silicium, le germanium, l'étain dans sa phase semiconductrice, et les alliages formés de ces éléments, par exemple le SiGe, le GeSn, le SiGeSn. Dans le cas de diodes électroluminescentes, le matériau semiconducteur d'intérêt peut être un composé semiconducteur III-V à base de GaN. Autrement dit, la diode est réalisée en un matériau semiconducteur dont au moins 50% de son volume est formé ou comporte du GaN ou un alliage de GaN, par exemple de l'InGaN ou de l'AlGaN.

Pour des raisons de clarté, on illustrera tout d'abord des exemples de dispositifs optoélectroniques comportant une pluralité de diodes, obtenus par un procédé de fabrication selon des variantes de réalisation.

Les figures 1A et 1B sont des vues en coupe, schématique et partielle, de deux exemples d'un dispositif optoélectronique 1 obtenu selon des variantes d'un procédé de fabrication.

D'une manière générale, le dispositif optoélectronique 1 comporte :
∘ un substrat fonctionnalisé dit de lecture 10, contenant un circuit de lecture 12, et comportant une pluralité de portions conductrices 20, distinctes les unes des autres, définissant une face de croissance du substrat de lecture 10 et connectées au circuit de lecture 12 ;
∘ une pluralité de portions de nucléation 30, distinctes les unes des autres, disposées au contact des portions conductrices 20, et réalisées en un matériau cristallin bidimensionnel ;
∘ la pluralité de diodes 40, réalisées par croissance épitaxiale de type van der Waals à partir des portions de nucléation 30.

On définit ici et pour la suite de la description un repère direct tridimensionnel orthogonal XYZ, où les axes X et Y forment un plan parallèle au plan principal du substrat de lecture 10, et où l'axe Z est orienté de manière sensiblement orthogonale au plan principal du substrat de lecture 10. Dans la suite de la description, les termes « inférieur » et « supérieur » s'entendent comme étant relatifs à un positionnement croissant lorsqu'on s'éloigne du substrat de lecture 10 suivant la direction +Z.

Le substrat de lecture 10 est formé d'un substrat support 11 contenant le circuit de lecture 12 de type circuit CMOS, adapté à commander et lire les diodes 40. Le substrat de lecture 10 présente une face dite de croissance, à partir de laquelle sont réalisées les diodes 40. Il comporte en outre une pluralité de portions conductrices 20, distinctes les unes des autres, qui définissent la face de croissance du substrat de lecture 10 et sont connectées au circuit de lecture 12.

Le circuit de lecture 12 comporte ainsi des éléments électroniques actifs ou passifs, tels que des diodes, transistors, condensateurs, résistances..., connectés électriquement par des interconnections métalliques aux diodes 40. Il comporte un niveau d'interconnexion électrique supérieur comportant des portions 15 d'une ligne métallique, électriquement reliée à des portions 13 de ligne métallique d'un niveau inférieur d'interconnexion électrique par des vias conducteurs 14. Les vias et lignes métalliques sont séparés les uns des autres par des couches diélectriques inter-métal 16. Le substrat de lecture 10 comporte ici une face supérieure plane 10a au niveau de laquelle affleurent les portions conductrices 15 de la ligne métallique du dernier niveau d'interconnexion, ainsi que la couche diélectrique inter-métal 16. A titre illustratif, les vias conducteurs 14 et les portions conductrices 13, 15 de lignes métalliques peuvent être réalisés en cuivre, en aluminium ou en tungstène, par un procédé damascène dans lequel on remplit avec du cuivre des tranchées réalisées dans la couche diélectrique inter-métal 16. Le cuivre ou le tungstène peut éventuellement être intercalé transversalement entre des couches verticales en nitrure de titane, de tantale ou autre. L'affleurement des portions conductrices 15 au niveau de la face supérieure plane 10a du substrat de lecture 10 peut être obtenu par une technique de planarisation mécano-chimique (CMP).

La face de croissance est définie par une pluralité de portions conductrices 20, réalisées en au moins un matériau électriquement conducteur, par exemple métallique, distinctes les unes des autres, et connectées au circuit de lecture 12. Les portions conductrices 20 sont dites distinctes les unes des autres, dans le sens où elles sont physiquement distinctes et électriquement isolées les unes des autres dans le plan XY. Chaque portion conductrice 20 est destinée à porter une diode 40 à un potentiel électrique imposé par le circuit de lecture 12, permettant ainsi d'injecter ou de collecter des porteurs de charge dans la diode 40. Comme illustré sur les figures, les portions conductrices 20 peuvent être en saillie vis-à-vis d'un plan passant par une face supérieure plane 10a du substrat de lecture 10, ou affleurer la face supérieure plane 10a. Par affleurer, on entend « arriver au niveau de » ou « s'étendre à partir de ».

Ainsi, la fig. 1A illustre un exemple où les portions conductrices 20 sont les portions 15 de la ligne métallique du dernier niveau d'interconnexion, qui affleurent la face supérieure plane 10a du substrat de lecture 10. Elles sont séparées les unes des autres dans le plan XY par la couche diélectrique inter-métal 16.

La fig. 1B illustre un autre exemple où les portions conductrices 20 sont des plots métalliques situés au contact des portions 15 de la ligne métallique du dernier niveau d'interconnexion, ces dernières affleurant la face supérieure plane 10a du substrat de lecture 10. Les portions conductrices 20 sont des plots réalisées en au moins un matériau métallique, par exemple en or, cuivre, aluminium, platine, TiN, entre autres. Elles sont distinctes les unes des autres dans le plan XY. Elles présentent des dimensions dans le plan XY qui dépendent des dimensions latérales souhaitées des diodes 40. Les dimensions latérales peuvent être comprises entre 500nm et quelques millimètres, selon les applications visées des diodes 40, et de préférence comprises entre 1µm et 10µm. Elles présentent une épaisseur, suivant l'axe Z, par exemple comprise entre 50nm et 1µm.

Le dispositif optoélectronique 1 comporte une pluralité de portions de nucléation 30, permettant la nucléation et la croissance épitaxiale des diodes 40. Elles sont distinctes les unes des autres, dans le sens où elles sont physiquement distinctes et électriquement isolées les unes des autres dans le plan XY. Elles sont disposées au contact des portions conductrices 20, et peuvent ainsi participer à injecter les porteurs de charge dans les diodes 40 ou à collecter les porteurs de charge photogénérés. Elles présentent des dimensions latérales dans le plan XY de préférence sensiblement égales voire inférieures à celles des portions conductrices 20.

Les portions de nucléation 30 sont réalisées d'une ou plusieurs monocouches d'un matériau cristallin bidimensionnel. Ce matériau bidimensionnel est choisi en fonction du matériau semiconducteur d'intérêt des diodes 40. Ainsi, lorsque celui-ci est un alliage de type II-VI, le matériau bidimensionnel est de préférence choisi parmi le graphène ou un dichalcogénure d'un métal de transition, tel que le MoS₂, MoSe₂, WSe₂, MoTe₂, WTe₂, ZrS₂, TiS₂, entre autres. Dans le cas où le matériau bidimensionnel est un alliage de type III-V, le matériau bidimensionnel est de préférence choisi parmi le graphène, un dichalcogénure d'un métal de transition, voire un monochalcogénure notamment à base de Ga, Te ou Se, par exemple du GaSe, GaTe ou du InSe, en particulier lorsque le matériau semiconducteur d'intérêt est respectivement à base de Ga, Te ou Se. De préférence, les portions de nucléation 30 sont réalisées en sulfure de molybdène ou de tungstène, et les couches conductrices 20 sont réalisées en or. On obtient ainsi une adhérence plus élevée.

Le dispositif optoélectronique 1 comporte une matrice de diodes 40, qui présentent chacune une jonction semiconductrice de type pn ou pin, ou encore une jonction de diode dite « à barrière » (par exemple pBn ou nBn). Les diodes 40 sont des photodiodes ou des diodes électroluminescentes. Elles peuvent être adaptées à détecter ou à émettre un rayonnement électromagnétique d'intérêt, par exemple dans l'infrarouge ou le visible. D'une manière générale, les diodes 40 comportent une partie semiconductrice dopée n et une partie semiconductrice dopée p, entre lesquelles peut être présente une partie intrinsèque (non intentionnellement dopée). Les diodes 40 peuvent présenter une structure classique qui n'est pas décrite plus en détail ici. De manière connue en soi, la jonction semiconductrice peut être formée par deux parties semiconductrices dopées et empilées l'une sur l'autre, éventuellement séparées l'une de l'autre par une zone active comportant éventuellement des puits quantiques. Elle peut également être formée par un caisson dopé localement et situé en surface d'une partie semiconductrice.

Les diodes 40 sont réalisées à base du matériau semiconducteur d'intérêt, par exemple à base de CdTe, d'InGaAs, d'antimoine Sb, de GaN, de Si et/ou de Ge etc. Elles comportent chacune une face inférieure située au contact des portions de nucléation 30, une face supérieure 40a opposée suivant l'axe Z et formant une face d'émission ou de réception optique, ainsi qu'une face latérale 40b qui relie les faces inférieure et supérieure entre elles et délimite transversalement la diode dans le plan XY. Les diodes 40 peuvent présenter différentes formes dans le plan XY, par exemple une forme polygonale, par exemple carrée, rectangulaire, triangulaire, hexagonale, voire une forme circulaire ou ovale. Le diamètre des diodes 40 est ici une grandeur associée à son périmètre au niveau d'une section dans le plan XY. Le diamètre de chaque diode 40 peut être constant suivant l'axe Z, voire peut varier suivant la direction +Z. Les dimensions sont de préférence identiques, d'une diode à l'autre. Les dimensions latérales, dans le plan XY, peuvent être comprises entre 500nm et quelques millimètres, selon les applications visées, et de préférence comprises entre 1µm et 10µm.

Le dispositif optoélectronique 1 comporte une couche isolante intercalaire 50, qui s'étend au contact de chaque diode 40 dans le plan XY et remplit l'espacement inter-diode. Cette couche 50 s'étend de préférence entièrement le long des faces latérales 40b des diodes 40 suivant l'axe Z, ici à partir de la face de croissance du substrat de lecture 10. Elle assure avantageusement la passivation des flancs latéraux des diodes 40, permettant ainsi de réduire la composante surfacique du courant d'obscurité (photodiodes) ou de limiter l'effet des éventuels états de surface pouvant conduire à des recombinaisons non radiatives (diodes émissives). On améliore ainsi les propriétés optiques et/ou électroniques des diodes 40. La couche isolante intercalaire 50 est réalisée en au moins un matériau électriquement isolant, par exemple diélectrique, qui peut dépendre du matériau semiconducteur d'intérêt des diodes 40. Elle assure une isolation électrique des diodes 40 entre elles dans le plan XY. Elle peut être formée en un même matériau électriquement isolant, ou peut être formée de différentes couches en des matériaux différents, par exemple d'une sous-couche de passivation 51 recouverte d'une couche de remplissage 52.

Ainsi, la fig. 1A illustre un exemple où la couche isolante intercalaire 50 est formée d'une sous-couche de passivation 51 qui est au contact et recouvre la face latérale 40b des diodes 40, et d'une couche de remplissage 52 qui recouvre la sous-couche de passivation 51 et remplit l'espacement inter-diode dans le plan XY. Dans cet exemple, la couche isolante intercalaire 50 s'étend à partir du substrat de lecture 10 suivant l'axe Z : elle assure donc l'isolation physique et électrique à la fois des portions de nucléation 30 entre elles d'une part, et des diodes 40 entre elles d'autre part. La couche isolante intercalaire 50 peut être réalisée en des matériaux différents (passivation et remplissage). A titre d'exemple, lorsque les diodes 40 sont réalisées à base de CdHgTe, la sous-couche de passivation 51 peut être réalisée en CdTe, et la couche de remplissage 52 peut être réalisée en ZnS, SiO, ou SiN, entre autres.

La fig.1B illustre un autre exemple où la couche isolante intercalaire 50 comporte une partie isolante inférieure 53 et une partie isolante supérieure empilées l'une sur l'autre suivant l'axe Z. Plus précisément, la partie isolante inférieure 53 s'étend ici au contact et à partir de la face de croissance suivant l'axe Z, et s'étend entre et au contact des portions conductrices 20 et des portions de nucléation 30. Elle peut notamment correspondre à un masque de croissance utilisé lors de l'épitaxie des diodes 40. Elle présente une épaisseur au moins égale à l'épaisseur des portions conductrices 20 et des portions de nucléation 30. La partie isolante inférieure 53 peut être réalisée en au moins un matériau diélectrique, par exemple un oxyde de silicium SiO ou un nitrure de silicium SiN, entre autres.

La partie isolante supérieure s'étend suivant l'axe Z à partir de la partie isolante inférieure 53, et s'étend dans le plan XY entre et au contact des diodes 40. Elle est formée ici d'une sous-couche de passivation 51 située au contact des faces latérales, et d'une couche de remplissage 52. A titre d'exemple, lorsque les diodes 40 sont réalisées en un matériau semiconducteur de type III-V, par exemple en InSb, la sous-couche de passivation 51 peut être un oxyde du matériau semiconducteur III-V, obtenue par exemple par oxydation électrochimique du matériau semiconducteur III-V, et la couche de remplissage 52 peut être un oxyde ou un nitrure de silicium, qui recouvre la sous-couche de passivation 51 et remplit l'espacement entre les diodes 40 dans le plan XY.

Le dispositif optoélectronique 1 comporte une électrode de polarisation supérieure, sous la forme ici d'une couche conductrice supérieure 60 s'étendant au contact de la face supérieure 40a de chaque diode 40, et connectée au circuit de lecture 12. La couche conductrice supérieure 60 est réalisée en au moins un matériau électriquement conducteur. Il peut ainsi s'agir d'ITO, de ZnO éventuellement dopé, de pérovskites tels que le SrTiO₃ et le Cd₃TeO₆, le CdO dopé, l'In₂O₃ éventuellement dopé, le TiO₂, le VO₂, entre autres. Elle peut s'étendre de manière à recouvrir continûment les faces supérieures 40a des diodes 40 (fig. 1A) et est donc réalisée en au moins un matériau conducteur transparent au rayonnement électromagnétique d'intérêt. Par transparent, on entend que le coefficient de transmission est supérieur ou égal à 50% pour une longueur d'onde centrale du rayonnement électromagnétique d'intérêt. Elle peut également s'étendre partiellement sur les faces supérieures 40a des diodes 40 (fig.lB), en particulier en bordure de celles-ci, de manière à diminuer une éventuelle absorption optique. En ce cas, l'électrode forme une grille de contact connexe (en vue de dessus) et on pourra privilégier une électrode faite en métal dans la mesure où elle ne fera pas obstacle à la lumière entrant ou sortant par les faces supérieures des diodes. Dans ce cas, une couche transparente isolante 61 peut recouvrir les diodes 40 et la couche conductrice supérieure 60. Cette couche transparente isolante 61 peut présenter une structuration de surface pour notamment améliorer l'extraction et/ou la focalisation optique, entre autres. D'autres variantes sont possibles. Ainsi, la couche conductrice supérieure 60 peut être une couche mince continue au moins partiellement transparente, sur laquelle s'étend une grille métallique située en regard de la couche isolante intercalaire 50, cette grille permettant ainsi de mieux récupérer/extraire les porteurs de charge et de compenser l'éventuelle forte résistivité électrique de la couche mince 60. La couche mince 60 peut être réalisée, outre en les matériaux indiqués précédemment, en silicium amorphe dopé, ce qui permet d'améliorer la passivation de la face supérieure des diodes.

Ainsi, comme décrit en détail plus loin, le dispositif optoélectronique 1 comporte une matrice de diodes 40 obtenues à partir d'un substrat de lecture 10 au moyen de portions de nucléation 30 en un matériau cristallin bidimensionnel, lesquelles sont en contact électrique avec des portions conductrices 20 connectées au circuit de lecture 12. Les diodes 40 sont réalisées par épitaxie van der Waals à partir du matériau bidimensionnel des portions de nucléation 30. Elles présentent donc un réseau cristallin qui n'est pas contraint mécaniquement par celui des portions de nucléation 30, ni par le substrat de lecture 10. Ainsi, le paramètre de maille effectif du matériau semiconducteur des diodes 40, en particulier celui des parties inférieures au contact des portions de nucléation 30 est sensiblement égal à sa valeur à l'état naturel (non contraint). Cela se traduit par une bonne relaxation des contraintes mécaniques du matériau semiconducteur des diodes 40 suivant toute son épaisseur, conduisant ainsi à une faible densité de défauts structuraux tels que les dislocations de désaccord de maille issues d'une éventuelle relaxation plastique des contraintes. Ainsi, il est alors possible de réaliser des parties semiconductrices dopées formant la jonction pn ou pin dont l'épaisseur n'est plus limitée par une épaisseur critique à partir de laquelle une relaxation plastique des contraintes mécaniques apparaît habituellement, améliorant ainsi le rendement quantique interne des diodes 40. La composition du matériau semiconducteur d'intérêt des diodes 40 peut également être adaptée pour obtenir la longueur d'onde de coupure voulue en fonction des applications visées. Ainsi, l'invention permet de réaliser un détecteur InAsSb pour une application LWIR, alors qu'un substrat de croissance présentant un paramètre de maille adapté à ce matériau pour cette application fait actuellement défaut.

Par ailleurs, les diodes 40 sont pixellisées dès la croissance épitaxiale à partir des portions de nucléation 30 distinctes les unes des autres. On réduit ainsi les risques de dégradation de la qualité cristalline du matériau semiconducteur des diodes 40, notamment au niveau des flancs latéraux, puisque la pixellisation des diodes 40 n'est pas effectuée par une étape de croissance d'un empilement semiconducteur suivie d'une étape de gravure localisée pour pixelliser les diodes 40. Les propriétés optiques et/ou électroniques du dispositif optoélectronique 1 sont ainsi améliorées.

Par ailleurs, comme explicité plus loin, les diodes 40 sont réalisées à partir du substrat de lecture 10 au moyen des portions de nucléation 30 en matériau bidimensionnel formées au contact des portions conductrices 20. On évite ainsi les étapes d'hybridation, c'est-à-dire d'assemblage mécanique par report et de connexion électrique, d'une puce optoélectronique sur une puce de commande. On évite ainsi les risques de désalignement et/ou de perte de contact mécanique et donc électrique entre les plots d'interconnexion de la puce de commande et les diodes 40 de la puce optoélectronique. Il est alors possible que le dispositif optoélectronique 1 comporte une matrice de diodes 40 comporte un grand nombre de diodes 40 à faible pas. De plus, la composition du matériau formant des diodes voisines peut être différente d'une diode à l'autre, autorisant à réaliser un dispositif multi-spectral.

Les figures 2A à 2G sont des vues schématiques et partielles, en coupe, de différentes étapes d'un procédé de fabrication d'un dispositif optoélectronique 1 à matrice de photodiodes 40, selon une variante du mode de réalisation illustré sur la fig. 1A.

En référence à la fig.2A, on réalise un substrat de lecture 10, formé d'un substrat support 11 contenant un circuit de lecture 12 de type CMOS. Le circuit de lecture 12 comporte différentes portions 13, 15 de ligne métallique, séparées les unes des autres dans le plan XY par une couche diélectrique inter-métal 16, ici en un oxyde de silicium. Les portions 13, 15 des différents niveaux d'interconnexion sont connectées entre elles par des vias conducteurs 14, et sont ainsi connectées au circuit de lecture 12. Des portions 15 de la ligne métallique du dernier niveau d'interconnexion affleurent la face supérieure plane 10a du substrat de lecture 10.

En référence à la fig.2B, on réalise les portions conductrices 20 par des étapes classiques de dépôt, photolithographie et gravure localisée. Dans cet exemple, celles-ci sont en saillie vis-à-vis de la face supérieure plane 10a du substrat de lecture 10, et sont disposées en contact des portions 15 de la ligne métallique du dernier niveau d'interconnexion. La face supérieure des portions conductrices 20 participe à définir la face de croissance du substrat de lecture 10. Dans cet exemple, elles présentent des dimensions latérales sensiblement égales à celles des portions de la ligne métallique, mais elles peuvent présenter des dimensions différentes. Les portions conductrices 20 sont ici préférentiellement réalisées en or. Elles présentent ici une épaisseur de l'ordre de 500nm et des dimensions latérales de l'ordre de 10µm. Elles sont ainsi distinctes les unes des autres dans le plan XY et sont adaptées à polariser les diodes 40.

En référence à la fig.2C, on réalise les portions de nucléation 30 sur et au contact des portions conductrices 20. Pour cela, on peut déposer au préalable un premier masque 71 formé ici d'une résine photosensible. Ce masque 71 s'étend sur la surface laissée libre de la face supérieure plane 10a du substrat de lecture 10, c'est-à-dire entre les portions conductrices 20. Ce masque 71 présente de préférence une épaisseur supérieure à celle des portions conductrices 20 et des portions de nucléation 30, par exemple de l'ordre de 1µm. Les portions de nucléation 30 sont réalisées en un matériau cristallin bidimensionnel. Dans le cas où les portions conductrices 20 sont réalisées en or, le matériau cristallin bidimensionnel est avantageusement un matériau soufré, et peut être le MoS₂ du fait de la forte affinité entre l'or et le soufre, permettant ainsi de réduire les risques de délamination. De plus, le matériau cristallin bidimensionnel est ici électriquement conducteur, de manière à permettre la polarisation des diodes 40. Il peut présenter un faible nombre de monocouches atomiques, par exemple être formé d'une unique monocouche, de manière à favoriser la transmission du courant électrique notamment par effet tunnel. Les portions de nucléation 30 peuvent être réalisées par épitaxie par jets moléculaires (MBE, pour *Molecular Beam Epitaxy,* en anglais), par dépôt chimique en phase vapeur (CVD, pour *Chemical Vapor Deposition,* en anglais) tel que le dépôt chimique en phase vapeur aux organométalliques (MOCVD) ou le dépôt en couches atomiques (ALD, pour *Atomic Layer Deposition,* en anglais), entre autres. La température de réalisation des portions de nucléation 30 est de préférence inférieure ou égale à 400°C, de manière à éviter toute dégradation du circuit de lecture 12. Le matériau cristallin bidimensionnel est ici déposé tant sur la face supérieure des portions conductrices 20 que sur la face supérieure du premier masque.

En référence à la fig.2D, on supprime ensuite le premier masque, par exemple par *lift-off.* On obtient ainsi une pluralité de portions de nucléation 30, réalisées en un matériau cristallin bidimensionnel, distinctes les unes des autres dans le plan XY, reposant sur et au contact des portions conductrices 20.

En variante, les portions de nucléation 30 peuvent être formées par transfert ou report d'une couche continue en un matériau cristallin bidimensionnel, en particulier lorsque la face de croissance est plane et coïncide avec la face supérieure plane 10a du substrat de lecture 10, autrement dit lorsque les portions conductrices 20 ne sont pas en saillie vis-à-vis de la face supérieure plane 10a mais affleurent cette dernière. La couche continue en le matériau cristallin bidimensionnel peut être une couche continue de graphène formée par graphitisation d'un substrat de SiC à réseau cristallin hexagonal par recuit à haute température sous vide, suivie d'un report de la couche continue de graphène sur la face supérieure plane 10a du substrat de lecture 10. Une étape de gravure localisée de la couche continue de graphène est ensuite mise en œuvre de manière à obtenir les portions de nucléation 30, distinctes les unes des autres, et situées sur et au contact des portions conductrices 20. A ce titre, l'article d'Avouris et Dimitrakopoulos intitulé Graphene : synthesis and applications, Materialstoday, 03/2012, Vol. 15, n°3, détaille des techniques classiques permettant de réaliser une couche continue de graphène, notamment la graphitisation du substrat de SiC suivie du report.

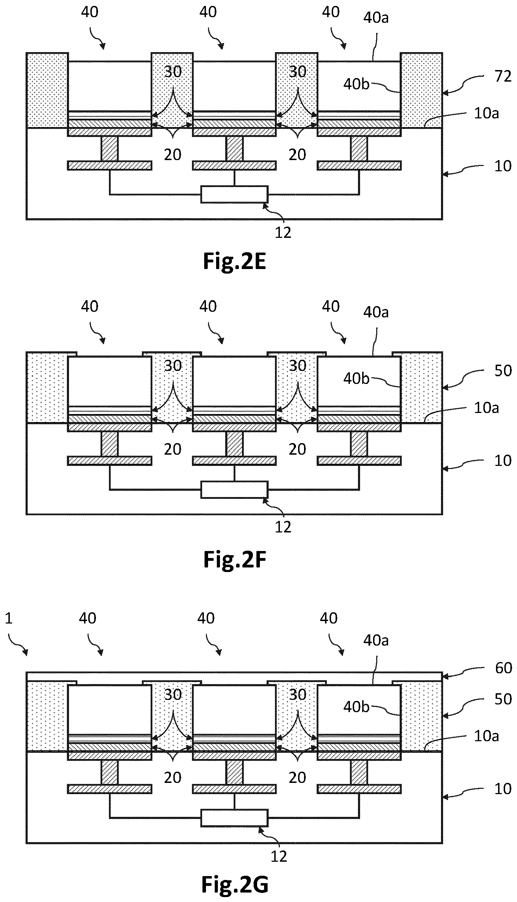

En référence à la fig.2E, on réalise les diodes 40 par épitaxie van der Waals à partir des portions de nucléation 30. Pour cela, on réalise au préalable un deuxième masque 72, ici un masque de croissance, situé sur la surface laissée libre de la face supérieure plane 10a du substrat de lecture 10, c'est-à-dire entre les portions conductrices 20 et les portions de nucléation 30. Le masque de croissance 72 présente ici une épaisseur suivant l'axe Z supérieure ou égale à l'épaisseur finale des diodes 40, mais en variante peut présenter une épaisseur inférieure à celle-ci. Il peut être réalisé en un matériau diélectrique, par exemple un oxyde de silicium SiO ou un nitrure de silicium SiN, entre autres.

On réalise ensuite les diodes 40 par croissance épitaxiale à partir des portions de nucléation 30 d'un matériau semiconducteur d'intérêt de type II-VI, de type III-V, voire de type IV. Cette étape de croissance épitaxie peut comporter une phase de nucléation suivie d'une phase de croissance proprement dite, ces deux phases se distinguant l'une de l'autre par les conditions de croissance et en particulier par la valeur de la température de croissance. En variante, l'étape de croissance épitaxiale peut comporter une seule et même phase de nucléation et de croissance.

La croissance peut être réalisée par des techniques d'épitaxie classiques telles que le dépôt chimique en phase vapeur (CVD) par exemple aux organométalliques (MOCVD), l'épitaxie par jets moléculaires (MBE), l'épitaxie en phase vapeur aux hydrures (HVPE, pour *Hybrid Vapor Phase Epitaxy*)*,* l'épitaxie par couche atomique (ALE, pour *Atomic Layer Epitaxy*), le dépôt par couche atomique (ALD), voire le dépôt par évaporation ou pulvérisation cathodique (*sputtering,* en anglais). A titre illustratif, les diodes 40 sont réalisées par épitaxie MBE à une température de croissance de l'ordre de 400°C environ, de manière à éviter toute dégradation du circuit de lecture 12.

Ainsi, le matériau semiconducteur des diodes 40 est lié aux portions de nucléation 30 par des liaisons faibles de type van der Waals, et non pas par des liaisons covalentes ou ioniques. Le matériau semiconducteur peut ainsi nucléer à son paramètre de maille sensiblement naturel, et n'est donc sensiblement pas contraint par un éventuel désaccord de maille entre les portions de nucléation 30 et le matériau semiconducteur.

En référence à la fig.2F, on réalise la couche isolante intercalaire 50. Pour cela, on supprime tout d'abord le masque de croissance 72, par exemple par voie chimique sélective. Dans cet exemple, celui-ci est supprimé sur toute son épaisseur, mais en variante, et comme détaillé plus loin, une partie inférieure du masque de croissance située au contact du substrat de lecture 10 peut être gardée. On dépose ensuite la couche isolante intercalaire 50, réalisée en au moins un matériau électriquement isolant, de manière à venir au contact des faces latérales 40b des diodes 40 suivant toute l'épaisseur de ces dernières, et à remplir l'espacement entre les diodes 40. A titre d'exemple, dans le cas de diodes 40 réalisées à base de CdHgTe, la couche isolante intercalaire 50 peut ainsi être formée d'une sous-couche de passivation en CdTe qui s'étend au contact de la face latérale 40b des diodes 40, revêtue d'une couche de remplissage en ZnS, SiO, SiN, entre autres, qui recouvre la sous-couche de passivation et remplit l'espacement inter-diode. La sous-couche de passivation peut également être réalisée par oxydation du matériau semiconducteur des diodes 40. En variante, dans le cas de diodes 40 réalisées à base d'un composé semiconducteur III-V, la couche isolante intercalaire 50 peut être réalisée en un même matériau, par exemple en un oxyde de silicium, un nitrure de silicium, un oxynitrure de silicium, ou en Al₂O₃, entre autres. La couche isolante intercalaire 50 débouche sensiblement au niveau de la face supérieure 40a des diodes 40. Dans cet exemple, elle recouvre une partie de la bordure latérale de la face supérieure 40a.

En référence à la fig.2G, on réalise la couche conductrice supérieure 60, de manière à venir au contact de la face supérieure 40a des diodes 40. Dans cet exemple, la couche conductrice supérieure 60 recouvre entièrement la face supérieure 40a des diodes 40. Elle est donc réalisée en un matériau, non seulement électriquement conducteur, mais également transparent au rayonnement électromagnétique d'intérêt. Le choix du matériau dépend notamment de la longueur d'onde centrale de la gamme spectrale de détection ou d'émission des diodes 40. La couche conductrice supérieure 60 peut être réalisée par un dépôt CVD, par exemple par dépôt ALD, par pulvérisation assistée par faisceaux d'ions (IBS, pour *Ion Beam Sputtering,* en anglais), voire par dépôt sol-gel, entre autres. La couche conductrice supérieure 60 est connectée au circuit de lecture 12 du substrat de lecture 10.

Ainsi, le procédé de fabrication permet de réaliser une matrice de diodes 40 à partir d'un substrat de lecture 10, par épitaxie de type van der Waals à partir d'une pluralité de portions de nucléation 30 réalisées en un matériau cristallin bidimensionnel, celles-ci étant situées au contact de portions conductrices 20 connectées au circuit de lecture 12. Comme mentionné précédemment, on écarte ainsi les problèmes que peuvent rencontrer les procédés d'hybridation par report de puces, notamment les problèmes de désalignement entre les plots de connexion respectifs de la puce de commande et de la puce optoélectronique, et on écarte les risques de défaut de contact électrique entre les diodes 40 et le circuit de lecture 12. Par ailleurs, on améliore la qualité cristalline du matériau semiconducteur des diodes 40 du fait que celui-ci n'est plus contraint par le paramètre de maille du matériau de nucléation, du fait qu'une épitaxie de type van der Waals est mise en œuvre. Le procédé de fabrication assure également une pixellisation des diodes 40 dès la croissance épitaxiale, et ne requiert pas de gravure localisée d'un empilement semiconducteur de couches cristallines continues pour former les diodes 40, comme c'est le cas notamment dans le cas des procédés de fabrication de type *loophole.* Le procédé de fabrication permet ainsi de réaliser une matrice de diodes 40 à haute qualité cristalline comportant un grand nombre de diodes 40 à faible pas.

Les figures 3A à 3D sont des vues schématiques et partielles, en coupe, de différentes étapes d'un procédé de fabrication d'un dispositif optoélectronique 1 à matrice de diodes 40 selon le mode de réalisation illustré sur la fig. 1B.

Les étapes de réalisation du substrat de lecture 10, des portions conductrices 20 et des portions de nucléation 30 sont identiques ou similaires à celles décrites en référence aux fig. 2A à 2D, et ne sont pas reprises ici.

En référence à la fig.3A, on réalise les diodes 40 par épitaxie van der Waals à partir des portions de nucléation 30 en un matériau cristallin bidimensionnel. Pour cela, on réalise au préalable un masque de croissance 72 situé sur la surface laissée libre de la face de croissance du substrat de lecture 10, c'est-à-dire entre les portions conductrices 20 et les portions de nucléation 30. Le masque de croissance 72 présente ici une épaisseur suivant l'axe Z inférieure à l'épaisseur finale des diodes 40, mais supérieure ou égale à l'épaisseur de la portion conductrice 20 et de la portion de nucléation 30. Ainsi, le masque de croissance 72 permet de garantir le maintien du positionnement dans le plan XY de chaque portion de nucléation 30 vis-à-vis de la portion conductrice 20 sous-jacente. A titre d'exemple, le masque de croissance 72 peut présenter une épaisseur de l'ordre de 500nm. Il peut être réalisé en un matériau diélectrique, par exemple un oxyde de silicium SiO ou un nitrure de silicium SiN, entre autres.

En référence à la fig.3B, on réalise ensuite une sous-couche de passivation 51 de la couche isolante intercalaire 50. Pour cela, on dépose localement tout d'abord un masque 73, ici une résine photosensible, de manière à recouvrir uniquement la face supérieure 40a des diodes 40. Ainsi, la face latérale 40b des diodes 40 est laissée libre, c'est-à-dire non recouverte. On effectue ensuite une oxydation électrochimique, de manière à former une sous-couche de passivation 51 réalisée en un oxyde du matériau semiconducteur des diodes 40. Cette sous-couche 51 recouvre ainsi la face latérale 40b de la diode 40 correspondante, de préférence continûment.

En référence à la fig.3C, on finalise ensuite la réalisation de la couche isolante intercalaire 50. Ainsi, on supprime la résine photosensible 73, et on garde le masque de croissance 72. Celui-ci forme alors la partie isolante inférieure 53 de la couche isolante intercalaire 50. On dépose ensuite la couche de remplissage 52, de manière à recouvrir la partie isolante inférieure 53 ainsi que les sous-couches de passivation 51. La couche de remplissage 52 affleure sensiblement au niveau de la face supérieure des diodes 40. Elle recouvre ici une bordure latérale de la face supérieure 40a des diodes 40.

En référence à la fig.3D, on réalise ensuite la couche conductrice supérieure 60, de manière à ce qu'elle vienne au contact de la face supérieure 40a de chaque diode. Dans cet exemple, la couche conductrice supérieure 60 ne recouvre pas entièrement les faces supérieures 40a mais recouvre uniquement une bordure latérale de ces dernières et forme une électrode à caractère préférentiellement connexe (contact restant commun à toutes les diodes). On limite ainsi l'éventuelle absorption partielle du rayonnement électromagnétique d'intérêt par la couche conductrice supérieure 60. Une couche de protection 61, réalisée en un matériau électriquement isolant et transparent au rayonnement électromagnétique d'intérêt est ensuite déposé de manière à recouvrir continûment les diodes 40 ainsi que la couche conductrice supérieure 60. Elle peut présenter une structuration en surface présentant une fonction optique définie (extraction lumineuse, mise en forme du faisceau lumineux émis ou reçu...)

On obtient ainsi un dispositif optoélectronique 1 à matrices de diodes 40 réalisées à partir d'un substrat de lecture 10 et présentant une bonne qualité cristalline, au moyen de portions de nucléation 30 en un matériau cristallin bidimensionnel disposées au contact de portions conductrices 20 du substrat de lecture 10.

Les figures 4A à 4D sont des vues schématiques et partielles, en coupe et en vue de dessus suivant le plan A-A, de différentes étapes d'un procédé de fabrication d'un dispositif optoélectronique 1 selon une variante de réalisation. Le procédé de fabrication est similaire à ceux décrits précédemment, et en diffère notamment en ce qu'il permet d'améliorer la conduction électrique entre les portions conductrices 20 et les portions de nucléation 30.

Certaines étapes sont identiques ou similaires à celles décrites précédemment et ne sont pas reprises ici. Par souci de clarté, les étapes de réalisation d'une seule diode de la matrice sont ici représentées.

En référence à la fig.4A, on réalise tout d'abord, pour chaque diode 40, une portion conductrice 20 qui comporte une zone principale 21 destinée à être revêtue par la diode épitaxiée, et une zone latérale 22 qui s'étend dans le plan XY à partir de la zone principale 21. La zone latérale 22 présente des dimensions dans le plan XY de préférence inférieure à celles de la zone principale 21, et est destinée à améliorer le contact électrique avec la portion de nucléation 30.

En référence à la fig.4B, on réalise la portion de nucléation 30, comme décrit précédemment, de manière à ce qu'elle soit située sur et au contact de la portion conductrice 20, à la fois sur les zones principale 21 et latérale 22 de cette dernière. Elle comporte ainsi une partie latérale 32, située sur et au contact de la zone latérale 22, qui s'étend latéralement à partir d'une partie principale 31. La partie latérale 32 ne recouvre pas entièrement la zone latérale 22, de sorte qu'une face latérale de la portion de nucléation 30 y est située. Plus précisément, chaque zone principale 21 de la portion conductrice 20 est revêtue par la portion de nucléation 30, mais la zone latérale 22 n'est revêtue que partiellement par la portion de nucléation 30. Chaque partie latérale 32 de la portion de nucléation 30 présente ainsi une face latérale 32.3 située au-dessus de la zone latérale 22 de la portion conductrice 20, qui relie une face inférieure 32.1 de la portion de nucléation 30 au contact de la portion conductrice 20 et une face supérieure 32.2 opposée.

En référence à la fig.4C, on réalise ensuite, par des étapes classiques de dépôt, photolithographie et gravure, une partie latérale supérieure 23 de la portion conductrice 20, qui vient au contact de la tranche, c'est-à-dire de la face latérale 32.3 de la partie latérale 32 de la portion de nucléation 30, et vient avantageusement recouvrir la partie latérale 32. Cette partie latérale supérieure 23 de la portion conductrice s'étend continûment au contact de la zone latérale 22 et de la face latérale de la portion de nucléation 30, et laisse libre la zone principale 21. La partie latérale supérieure 23 s'étend au contact de la portion conductrice 20 sous-jacente, et au contact de la face latérale 32.3 de la portion de nucléation 30, et avantageusement au contact de la face supérieure 32.2. On peut ainsi considérer que la couche de nucléation 20 est formée d'une partie inférieure (indiqué par la référence 20 sur les figures) et par la partie latérale supérieure 23.

En référence à la fig.4D, on finalise la réalisation du dispositif optoélectronique 1 comme décrit précédemment, par les étapes d'épitaxie van der Waals des diodes 40 à partir de la partie principale 31 des portions de nucléation 30, de réalisation de la couche isolante intercalaire 50, et de réalisation de la couche conductrice supérieure 60. Ces étapes sont identiques ou similaires à celles décrites précédemment et ne sont pas reprises ici. En variante, l'étape d'épitaxie van der Waals peut être réalisée avant l'étape de réalisation des parties latérales supérieures 23. Les diodes 40 recouvrent la zone principale 21 mais ne recouvrent pas la zone latérale 22. La partie latérale supérieure 23 est avantageusement au contact d'une surface inférieure 40b.1 d'une face latérale de la diode 40.

On obtient ainsi un dispositif optoélectronique 1 dont le contact électrique entre les portions conductrices 20 et les portions de nucléation 30 est amélioré. En effet, il apparaît que le contact électrique dans le plan, entre les portions conductrices 20 et les portions de nucléation 30, peut être résistif en fonction des matériaux utilisés. Or, il apparaît que le contact électrique peut être moins résistif lorsqu'il a lieu notamment au niveau de la tranche des portions de nucléation 30, c'est-à-dire par la face latérale qui relie les faces inférieure et supérieure des portions de nucléation 30. La partie latérale supérieure 23 des portions conductrices 20 comporte en effet une zone qui vient au contact de la tranche des portions de nucléation 30, améliorant ainsi la conduction électrique entre la portion conductrice et la portion de nucléation. Les performances du dispositif optoélectronique 1 sont alors préservées, voire améliorées.

Les figures 5A à 5D sont des vues schématiques et partielles, en coupe, de différentes étapes d'un procédé de fabrication d'un dispositif optoélectronique 1 selon une autre variante de réalisation. Le procédé de fabrication est similaire à ceux décrits précédemment, et en diffère notamment en ce qu'il permet d'améliorer la conduction électrique entre les portions conductrices 20 et les diodes 40. Certaines étapes sont identiques ou similaires à celles décrites précédemment et ne sont pas reprises ici.

En référence à la fig.5A, on réalise tout d'abord une matrice de diodes 40 par épitaxie van der Waals à partir des portions de nucléation 30. On veillera à ce que les jonctions de diodes soient préférentiellement positionnées à proximité ou au niveau de la partie sommitale des portions 40. Les portions conductrices 20 comportent chacune une zone latérale 22 dont une surface supérieure est libre, c'est-à-dire non revêtue par la portion de nucléation 30 et par les diodes 40. La zone latérale 22 s'étend ici sur tout le contour des diodes 40, mais peut n'être présente que sur une partie du contour. Chaque portion de nucléation 30 présente ainsi une face latérale 32.3 située au-dessus de la zone latérale 22 de la portion conductrice 20, qui relie une face inférieure 32.1 de la portion de nucléation 30 au contact de la portion conductrice 20 et une face supérieure 32.2 opposée.

En référence à la fig.5B, on réalise une gravure sélective isotrope des diodes 40 au niveau de leur face latérale 40b, de manière à ce que les faces latérales 40b présentent une surface inférieure 40b.1 inclinée. Pour cela, on dépose une résine photosensible de manière à recouvrir la face supérieure 40a des diodes 40 ainsi que les portions conductrices 20, les portions de nucléation 30 et le substrat de lecture 10. Ainsi, la face latérale 40b des diodes est laissée libre. La gravure sélective est effectuée par un agent de gravure réactif au matériau semiconducteur des diodes 40. La face latérale 40b des diodes présente alors un rétrécissement de son diamètre dans une zone médiane des diodes 40 suivant l'axe Z. Aussi, elle présente une surface inférieure 40b.1 inclinée, autrement dit concave, qui s'étend à partir de la portion de nucléation 30 suivant l'axe Z.

En référence à la fig.5C, on réalise ensuite, par des étapes classiques de dépôt, photolithographie, gravure, une partie latérale supérieure 23 des portions conductrices 20, qui s'étend continûment au contact de la zone latérale 22 de la portion conductrice et de la surface inférieure inclinée 40b.1. Pour cela, on revêt les diodes 40 et le substrat de lecture 10 d'une résine photosensible (non représentée), que l'on gravure localement uniquement au niveau des surfaces inférieures inclinées 40b.1 et au niveau de la surface supérieure libre de la zone latérale 22 des portions conductrices 20. La tranche des portions de nucléation 30 est également rendue libre. On réalise ensuite un dépôt d'un matériau conducteur, de préférence identique à celui des portions conductrices 20, par exemple en or, de manière à former une partie latérale supérieure 23 recouvrant continûment, pour chaque diode, la surface supérieure libre de la zone latérale 22 de la portion conductrice et la surface inférieure inclinée 40b.1 de la diode. La tranche de la portion de nucléation 30 est également recouverte par la partie latérale supérieure 23. On supprime ensuite par *lift-off* la résine photosensible et la couche d'or qui la recouvre. La partie latérale supérieure 23 s'étend au contact de la portion conductrice 20 sous-jacente et au contact de la surface inférieure 40b. 1 de la diode 40, ainsi que, ici, au contact de la face latérale 32.3 de la portion de nucléation 30.

En référence à la fig.5D, on finalise la réalisation du dispositif optoélectronique 1 comme décrit précédemment, par les étapes de réalisation de la couche isolante intercalaire 50 et de réalisation de la couche conductrice supérieure 60. Ces étapes sont identiques ou similaires à celles décrites précédemment et ne sont pas reprises ici.

On obtient ainsi un dispositif optoélectronique 1 dont la conduction électrique entre les portions conductrices 20 et les diodes 40 est améliorée. En effet, il apparaît que le contact électrique dans le plan entre les portions de nucléation 30 et le matériau semiconducteur des diodes 40 peut être résistif en fonction des matériaux utilisés. Aussi, la partie latérale supérieure 23 des portions conductrices 20 permet d'améliorer la conduction électrique avec les diodes 40, en formant une zone supplémentaire de conduction électrique en bordure des portions de nucléation 30. Les performances du dispositif optoélectronique 1 sont alors préservées, voire améliorées.

Des modes de réalisation particuliers viennent d'être décrits. Différentes variantes et modifications apparaîtront à l'homme du métier.

Ainsi, la partie latérale périphérique des portions conductrices 20 décrite en référence aux figures 4D et 5D peut s'étendre sur toute la bordure des diodes 40 dans le plan XY, ou ne s'étendre que sur une partie de la bordure.

Les diodes 40 peuvent être identiques les unes aux autres notamment dans le cas de l'émission ou la détection monospectrale. En variante, elles peuvent différer entre elles par la composition du matériau semiconducteur, notamment dans le cas d'une utilisation multispectrale du dispositif optoélectronique 1. En ce cas, plusieurs étapes d'épitaxie successives sont appliquées en prenant soin de masquer, à chaque fois, les zones qui ne sont pas destinées à accueillir le matériau en cours de dépôt.

## Revendications

1. Procédé de fabrication d'un dispositif optoélectronique (1) comportant une pluralité de diodes (40), comportant les étapes suivantes :
∘ fourniture d'un substrat de lecture (10) contenant un circuit de lecture (12) comportant des lignes métalliques (13, 15) séparées les unes des autres par des couches diélectriques (16) dites inter-métal, et présentant une face de croissance définie par une pluralité de portions conductrices (20) en au moins un matériau métallique, distinctes les unes des autres, et connectées au circuit de lecture (12) ;
∘ réalisation, sur la face de croissance, d'une pluralité de portions de nucléation (30) en un matériau cristallin bidimensionnel, distinctes les unes des autres, et reposant au contact des portions conductrices (20) ;
∘ réalisation, par épitaxie à partir des portions de nucléation (30), de la pluralité de diodes (40).

2. Procédé selon la revendication 1, dans lequel le substrat de lecture (10) présente une face supérieure plane (10a), les portions conductrices (20) étant en saillie vis-à-vis de la face supérieure plane (10a) et reposent au contact de portions (15) des lignes métalliques du circuit de lecture (12).

3. Procédé selon la revendication 1, dans lequel le substrat de lecture (10) présente une face supérieure plane (10a), les portions conductrices (20) affleurant la face supérieure plane (10a) et forment des portions (15) des lignes métalliques du circuit de lecture (12).

4. Procédé selon l'une quelconque des revendications 1 à 3, dans lequel chaque portion conductrice (20) comporte :
▪ une zone dite principale (21) revêtue par la portion de nucléation (30), et destinée à être revêtue par la diode (40), et
▪ une zone dite latérale (22), revêtue partiellement par la portion de nucléation (30) de sorte que celle-ci présente une face latérale reliant des faces inférieure et supérieure de la portion de nucléation (30), et destinée à ne pas être revêtue par la diode (40), et s'étendant dans un plan parallèle au substrat de lecture (10) à partir de la zone principale (21),
∘ le procédé comportant une étape de réalisation d'une partie dite latérale supérieure (23) de la portion conductrice (20) s'étendant continûment au contact de la zone latérale (22) et au contact de la face latérale de la portion de nucléation (20).

5. Procédé selon l'une quelconque des revendications 1 à 4, dans lequel chaque portion conductrice (20) comporte :
▪ une zone dite principale (21) revêtue par la portion de nucléation (30) et par la diode (40), et
▪ une zone dite latérale (22) non revêtue par la diode (40), et s'étendant dans un plan parallèle au substrat de lecture (10) à partir de la zone principale (21),
∘ le procédé comportant une étape de réalisation d'une partie dite latérale supérieure (23) de la portion conductrice (20) s'étendant continûment au contact de la zone latérale (22) et au contact d'une surface inférieure (40b. 1) d'une face latérale (40b) de la diode (40).

6. Procédé selon la revendication 5, comportant, au préalable de l'étape de réalisation de la partie latérale supérieure (23), une étape de gravure partielle isotrope sélective des diodes (40) à partir d'une face latérale (40b) des diodes (40), la face latérale (40b) des diodes reliant une face inférieure au contact des portions de nucléation (30) et une face supérieure (40a) opposée, de sorte que la surface inférieure (40b.1) est inclinée suivant un axe orthogonal au plan du substrat de lecture (10).

7. Procédé selon l'une quelconque des revendications 1 à 6, comportant une étape de réalisation d'une couche isolante intercalaire (50), s'étendant au contact des diodes (40) dans un plan parallèle au substrat de lecture (10), et remplissant l'espacement entre les diodes (40).

8. Procédé selon la revendication 7, dans lequel la couche isolante intercalaire (50) comporte une sous-couche de passivation (51) s'étendant au contact d'une face latérale des diodes (40), et une couche de remplissage (52) recouvrant la sous-couche de passivation (51) et remplissant l'espacement inter-diode.

9. Dispositif optoélectronique (1), comportant :
∘ un substrat de lecture (10), contenant un circuit de lecture (12), et comportant une pluralité de portions conductrices (20) en au moins un matériau métallique, distinctes les unes des autres, définissant une face de croissance du substrat de lecture (10) et connectées au circuit de lecture (12), celui-ci comportant des lignes métalliques (13, 15) séparées les unes des autres par des couches diélectriques (16) dites inter-métal ;
∘ une pluralité de portions de nucléation (30), distinctes les unes des autres, disposées au contact des portions conductrices (20), et réalisées en un matériau cristallin bidimensionnel ;
∘ une pluralité de diodes (40), situées au contact des portions de nucléation (30).

10. Dispositif optoélectronique (1) selon la revendication 9, dans lequel les diodes (40) sont réalisées à base d'un matériau semiconducteur d'intérêt, lequel est un élément ou un composé de type II-VI, III-V, ou IV.

11. Dispositif optoélectronique (1) selon la revendication 9 ou 10, dans lequel chaque portion conductrice (20) comporte une zone latérale (22) revêtue partiellement par la portion de nucléation (30), et une partie dite latérale supérieure (23) qui s'étend continûment au contact de la zone latérale (22) et au contact d'une face latérale de la portion de nucléation (30).

12. Dispositif optoélectronique (1) selon l'une quelconque des revendications 9 à 11, dans lequel chaque portion conductrice (20) comporte une zone latérale (22) non revêtue par une diode (40), et une partie dite latérale supérieure (23) qui s'étend continûment au contact de la zone latérale (22) et au contact d'une surface inférieure (40b.1) d'une face latérale (40b) de la diode (40).

13. Dispositif optoélectronique (1) selon l'une quelconque des revendications 9 à 12, dans lequel au moins deux diodes sont réalisées en un matériau semiconducteur présentant des compositions différentes.

14. Dispositif optoélectronique (1) selon l'une quelconque des revendications 9 à 13, dans lequel les portions de nucléation (30) sont réalisées en sulfure de molybdène ou de tungstène, et les couches conductrices (20) sont réalisées en or.
